# EUROPEAN PATENT APPLICATION

(11) **EP 1 950 316 A1**
(43) Date of publication of application: **30.07.2008**
(21) Application number: 08008996.4
(22) Date of filing: 26.12.2003
(51) Int. Cl.: C22C 9/04

(54) **Metal material and manufacturing method**

(30) Priority: 27.12.2002 JP 2002379137
(62) Divisional of application: 03768299.4
(71) Applicant: SUMITOMO LIGHT METAL INDUSTRIES, LTD., Minato-ku, Tokyo 105-8601 (JP); Nitto Metal Industry Co, Ltd, Chiyoda-ku Tokyo 101-0032 (JP)
(72) Inventor: Ando, Tetsuya, Tokyo 105-8601 (JP); Mochizuki, Toshiharu, Tokyo 153-8530 (JP)
(74) Representative: Müller-Wolff, Thomas

(57) **Abstract**

A metal material comprising a Cu-Zn alloy in which a low melting point metal phase formed from Sn and Bi is dispersed in the form of particles and in a particle number concentration of 10⁴/mm³ or more, the metal material comprising 58 to 62% Cu and optionally up to 0,5% Fe, 1,0 to 4,5% Sn, 0,3 to 0,6% Bi, 0,02 to 0,04% P and Zn as remainder.

## Description

### TECHNICAL FIELD

The present invention relates to a metal material such as iron, stainless steel, copper alloy, aluminum alloy, and the like, particularly a metal material used for cutting work, and a method for manufacturing the same. The present invention further provides a metal material most suitable if applied to a copper alloy for cutting work and a method for manufacturing the same.

### BACKGROUND ART

Conventionally, many iron and steel materials (e.g. stainless steel), copper alloy materials, and aluminum alloy materials having free-machining properties contain about 0.35-10% of Pb. For example, free-machining copper alloys such as a Cu-Zn alloy excelling in machinability are registered in Japanese Industrial Standards (JIS) such as JIS C3600, C3700, etc. They are widely used for stopcocks, valve parts, roller bearings, gears, and the like.

In recent years, Pb has come to be regarded as a toxic substance hazardous to the human body and the environment. There is a worldwide tendency to limit its use. The above free-machining copper alloy containing Pb specified in JIS, if used as a component such as for a stopcock for water supply apparatuses, causes Pb to melt due to heat in cutting work. The melted Pb adheres to the surface of the material and is dissolved in drinking water coming in contact with the machined surface. The regulation for the amount of Pb elusion is steadily becoming more strict and the ordinance of the Health and Welfare Ministry now provides a 0.01 mg/l ceiling on Pb content in drinking water.

Since Bi is located next to Pb in the Periodic Table, Bi shares many characteristics with Pb. For this reason, a technique of replacing Pb with Bi, which is a low melting-point metal, has been proposed (Japanese Patent Application Laid-open No. 7-310133). To obtain excellent machinability without relying on the machining conditions of copper alloy for cutting work, for example, this technique is effective in reducing the dispersion diameter of low melting-point metal particles. However, since the particle size of Bi increases as the matrix particles grow due to the small wetting angle of Bi with a copper alloy as compared with Pb, Bi particles cannot be finely dispersed by simply replacing Pb with Bi. Thus, the machinability of such an alloy cannot be improved without improving the manufacturing process.

One of the inventors of the present invention has previously studied the effect of Bi on the machinability of a free-machining copper alloy in which Pb was replaced with Bi. Based on the finding that a free-machining copper alloy containing 0.5-4.0% of Bi and 0.1-1.0% of Pb, which are present in the matrix as a compound, can exhibit excellent machinability irrespective of machining conditions, the inventor entity including one of the inventors of the present invention applied for a patent application (Japanese Patent Application Laid-open No. 2002-146455).

However, to ensure the same machinability as a conventional Pb-containing copper alloy, the proposed free-machining copper alloy must contain Bi in an amount equivalent to or greater than Pb. Since Bi is a rare metal as compared with Pb and its availability is still insufficient, the cost of the copper alloy is unduly increased.

### DISCLOSURE OF THE INVENTION

As a result of extensive studies and experiments on the method for reducing the amount of Bi in a Bi-containing copper alloy while ensuring excellent machinability, the present inventors have found that if Sn is present together with Bi and/or Pb, Sn forms a low melting point compound, which makes it possible to reduce the respective amounts of Bi and Pb.

The present inventors have conducted further studies based on this finding and found that the above fact can also apply to other metal materials, leading to the completion of the present invention.

Specifically, an object of the present invention is to provide a metal material comprising a metal matrix in which a low melting point metal phase formed from Sn and at least one of Bi and Pb is dispersed in the form of particles, exhibiting excellent machinability irrespective of processing conditions, particularly when applied to a metal material for cutting work, most suitably, to a copper alloy for cutting work, being capable of satisfying the Pb elution control of 0.01 mg/l or less, and being advantageous in terms of production cost. The present invention further provides a method for manufacturing the metal material.

The metal material of the present invention for achieving the above object comprises a metal matrix in which a low melting point metal phase formed from Sn and Bi is dispersed in the form of particles.

In the metal material, the metal matrix is preferably formed by the reaction of Sn present as a solid solution in the metal matrix with Bi.

In the metal material, the metal matrix preferably contains the low melting point metal phase in a particle number concentration of 10⁴/mm³ or more in the metal matrix.

The metal material is used for cutting work.

In the metal material, the metal matrix is preferably a Cu-Zn alloy.

In the metal material, the content of Fe in the Cu-Zn alloy is preferably regulated to 0.5% or less.

In the metal material, the volume percentage of the low melting point metal phase in the metal matrix is preferably 0.35-10%.

In the metal material, the Cu-Zn alloy preferably contains 1.0-3.5% of Sn and 0.4-0.6% of Bi.

In the metal material, the Cu-Zn alloy preferably contains 2.0-4.5% of Sn and 0.4-0.6% of Bi.

In the metal material, the Cu-Zn alloy preferably contains P in an amount of 0.02-0.04.

The metal material is preferably used for cutting work as a casting material.

In the metal material, the Cu-Zn alloy preferably contains Sn and Bi, wherein the content of Bi is 0.3-2.9%.

In the metal material used for machining, the low melting point metal phase dispersed in the metal matrix is preferably deposited or dispersed in the form of particles adjacent to a hard and brittle alloy phase.

In the metal material, the volume percentage of the hard and brittle alloy phase adjacent to the low melting point metal phase is preferably 10% or less in the metal matrix.

A method for manufacturing the metal material comprises heating a metal matrix containing Sn and Bi to a temperature sufficient for the Sn to form a homogeneous solid solution in the metal matrix, quenching the metal matrix at a cooling rate sufficient to prevent deposition of Sn and a metal alloy phase of the Sn and the metal matrix, and reheating the metal matrix to react the Sn in a solid solution with Bi, thereby causing the resulting low melting point phase in the form of particles to homogeneously disperse.

Another method for manufacturing the metal material comprises heating a metal matrix containing Sn and Bi to a temperature sufficient for the Sn to form a homogeneous solid solution in the metal matrix and cooling the metal matrix at a sufficiently slow cooling rate to cause the Sn in a solid solution to react with Bi, thereby forming a low melting point phase in the form of particles to homogeneously disperse.

Still another method for manufacturing the metal material comprises maintaining a metal matrix containing Sn and Bi at 400°C or higher for one minute or more, thereby causing a low melting point phase to deposit in the metal matrix phase.

A further method of the present invention is a method for manufacturing the metal material, comprising subjecting the metal matrix to hot-working, cooling after hot-working, reheating at a temperature of 400°C or more, and retaining for more than one minute at a temperature of 400°C or more, or wherein the metal matrix is a copper alloy, comprising subjecting the metal matrix to hot-working, cooling after hot-working, cold-working, reheating at a temperature of 400°C or more, and retaining for more than one minute at a temperature of 400°C or more.

### BEST MODE FOR CARRYING OUT THE INVENTION

The features of the present invention will now be described.
(1) Sn produces a low melting point alloy by eutectic crystallization with Bi and Pb. The low melting point alloy has a melting point lower than either Bi or Pb since this is an eutectic alloy. In addition, since the eutectic composition is 57% in the case of Bi and 38% in the case of Pb, the effect obtained is twice as much as the effect obtained by the independent addition of Bi and Pb.
(2) When Bi, Pb, and Sn are added especially to a copper alloy, Bi and Pb do not form a solid solution, but are independently present in the matrix. Although Sn forms a solid solution in the matrix, the Sn in the form of a solid solution reacts with Bi and Pb by heat treatment and produces a low melting point alloy phase.
(3) Since the low melting point alloy phase finely dispersed in the metal matrix has a melting point lower than in the case where Bi and Pb are independently present, the metal material exhibits better machinability with a smaller number of dispersed particles (which is larger than 10⁴ per 1 mm³ of the material) than in the case where Bi and Pb are independently used.
(4) Since the amount of Sn in the form of a solid solution increases with an increase in the temperature, particularly in the case of a copper alloy, it is possible to cause Sn to form a solid solution in the matrix while suppressing deposition of Sn by rapidly cooling from a high temperature. Since the proportion of a high β phase of Sn with high solid-solubility increases at a high temperature in the Cu-Zn alloy, a more uniform concentration of Sn can be achieved by rapid quenching from a high temperature.
(5) Since the number of distributed particles increases by rapid quenching from a high temperature when the concentration is fixed, the amount to be added to obtain a certain number of distributed particles may be small.
(6) The Sn in the form of a solid solution and dispersed Bi and Pb are heated again to produce an alloy. In the alloying reaction, the diffusion length can be decreased by homogeneously forming a solid solution with Sn at a high concentration and increasing the number of distributed particles of Bi and Pb, whereby the alloying reaction is promoted. Since alloying occurs at locations in which Bi and Pb are present, the alloy phase can be finely dispersed by finely dispersing Bi and Pb. In the case of a copper alloy, formation of a low melting-point compound can be promoted regardless of the hot extrusion temperature by reheating the material at 400°C or more and maintaining the material at that temperature for one minute or more.
(7) The reheating can be replaced by slowly cooling the metal materials such as a copper alloy after hot working. Homogeneous forming of a solid solution of Sn and homogeneous dispersion of Bi and Pb are attained immediately after hot working and the temperature conditions equivalent to reheating can be obtained by slow cooling, whereby the alloying reaction proceeds. In slow cooling, the material may be cooled from a temperature of above 400°C to 400°C in one minute or more.
(8) The alloying reaction proceeds more efficiently if the amount of Sn for alloying with Bi and Pb is greater than a stoichiometric amount. When the amount of Sn is excessive, the Sn reacts with the metal matrix, thereby dispersing a hard phase. Specifically, when the hard phase deposited in the reaction with the metal matrix is dispersed forming a complex with the low-melting point alloy phase, the alloying of Sn with Bi and Pb can be regarded as sufficient.
(9) Particularly when the metal matrix is a copper alloy, the presence of a large amount of the hard phase inhibits the cold workability. Therefore, the volume percentage of the low melting point metal phase in the metal matrix is preferably 10% or less. When the metal matrix is a copper alloy, particularly a Cu-Zn alloy, a brittle y phase, of which the main component is CuZnSn, is formed adjacent to the low melting point metal phase by the reaction with the excessive Sn.
(10) Particularly when the metal matrix is a copper alloy, the low melting point alloy phase dispersed in the metal matrix adjoining the brittle alloy phase is deposited and dispersed, affording the metal material with excellent machinability. In the case of a Cu-Zn alloy, excellent machinability can be obtained by coexistence of the β phase, which affords good machinability, with the hard y phase and the low melting point alloy phase.
(11) In the metal material in which the metal matrix is a copper alloy, the existence of the low melting point alloy phase in an amount of 0.35-10% volume percentage can afford machinability equivalent to or better than that obtained in a conventional Pb-containing copper alloy for cutting work which contains the same amount of Pb.
(12) In the present invention, Sn is selected as a complex addition element for reducing the amount of Pb and Bi to be added. Thus, either Pb or Bi or both Pb and Bi can be added together with Sn. When Pb is added, that content should be 0.6% or less to satisfy the regulatory elution limit of 0.01 mg/l or less.

Now, describing the characteristics of metal materials for cutting work, of which the metal matrix is a copper alloy such as a Cu-Zn alloy, a low boiling point compound is produced by eutectic crystallization if Sn is present together with Bi. Taking into consideration that the eutectic composition of Sn and Bi is Sn-57% Bi, a preferable content of Bi is in the range of 0.3-2.9%.

Sn, if present together with Pb, also produces a low melting point alloy by eutectic crystallization. Taking into consideration that the eutectic composition of Sn and Pb is Sn-38% Pb, a preferable content of Pb is in the range of 0.2-1.9%. To satisfy the Pb elution control of 0.01 mg/l or less, however, the content of Pb must be 0.6% or less. Therefore, a preferable content of Pb is in the range of 0.2-0.6%.

When Sn is present together with Bi and Pb, a low melting point alloy is also produced by eutectic crystallization. The amount of Bi and Pb in this instance must follow the prerequisite of the Pb content of 0.6% or less. Therefore, a preferable content of Bi is from (0.3% - Pb content × 1.5) to (2.9% - Pb content × 1.5) when the content of Pb is less than 0.2% and (2.9% - Pb content × 1.5) or less when the content of Pb is 0.2-0.6%.

Sn should be present at least in the amount required for producing low melting point compounds of Sn-Bi, Sn-Pb, and Sn-Bi-Pb by eutectic crystallization, preferably 0.3% or more.

Because the metal material for cutting work, of which the metal matrix is a copper alloy such as a Cu-Zn alloy, having the above-mentioned composition provides excellent machinability by reheating treatment or slow cooling treatment after hot extrusion, selection of appropriate heat treatment conditions is essential. However, such excellent machinability can be ensured without being affected by heat treatment conditions if the following copper alloy composition (A) or (B) is selected.
(A) A copper alloy containing 1.0-3.5% of Sn and 0.4-0.6% of Bi and Pb in total.
(B) A copper alloy containing 2.0-4.5% of Sn and 0.4-0.6% of Bi and Pb in total.

To ensure dispersion of a sufficient number of particles (10⁴/mm³ or more) of low melting point alloy phase formed by the reaction of Sn with Bi and/or Pb in the matrix, it is necessary for Bi and Pb to be included in the total amount of 0.4% or more. To ensure dispersion of the low melting point alloy phase particles in the above amount when cooled at a sufficiently high cooling rate to prevent deposition of Sn and the alloy phase of Sn and the metal matrix, the Sn concentration must be 1.0% or more. However, too large an amount of low melting point alloy phase may result in large and rough particles of low melting point alloy depending on heat treatment conditions, which may cause cracking during the cutting work. To prevent cracking during the cutting work, it is preferable to control the total amount of Bi and Pb to 0.6% or less and the Sn concentration to 3.5% or less.

In the case in which Sn and the alloy phase of Sn and the metal matrix are deposited, to obtain dispersion conditions of 10⁴/mm³ or more, in terms of the number of particles, or 0.35-10%, in terms of volume percentage, of the low melting point alloy phase formed by the reaction of Sn with Bi and/or Pb in the matrix, the total amount of Bi and Pb must be 0.4% or more and the amount of Sn must be 2.0% or more. However, too large an amount of low melting point alloy phase may result in large and rough particles of the low melting point alloy depending on heat treatment conditions, which may cause cracking of the metal material during cutting work. To prevent the cracking during cutting work, it is a preferable to control the total amount of Bi and Pb to 0.6% or less and the Sn concentration to 4.5% or less.

Copper alloys having a composition of the above (A) or (B) can be used as a casting material for cutting work. However, in the case of a Cu-Zn alloy, molten metal flowability is inhibited if the alloy contains Sn and Bi. This is due to the direct decrease in flowability caused by an increase in the molten metal viscosity and an apparent decrease in flowability caused by coagulation which is generated when growth of dendrites is accelerated. A decrease in flowability leads to easy cracking due to coagulation when a casting product with a larger wall thickness is manufactured. When manufacturing a casting product with a small wall thickness, lack or chipping of material may easily occur. A method of decreasing the viscosity or suppressing growth of dendrites is effective in increasing flowability of the molten metal. This can be effectively achieved by adding P. A preferable amount of P to be added is 0.02-0.04%. The addition of P in an amount of more than 0.04% not only brings about no more effect on flowability improvement than that achieved by the addition of 0.04%, but also causes problems such as shearing cracks when billets are hot-extruded, thereby restricting extrusion conditions for obtaining good extrusion materials.

In manufacturing Cu-Zn alloys according to the present invention, use of Cu-Zn-containing scrap metal is advantageous in respect of processing, cost, and the like. Pb contained in alloys conforming to the JIS 3000 standard (Cu-Zn-type alloys) has a low surface energy as compared with Bi and has a tendency of being granulated into fine particles. However, when Bi forms eutectic crystals with Pb, the surface energy of Pb increases. If Bi is contained in an amount exceeding a certain figure, particles do not finely disperse as in the case of using Pb alone, but become large and rough. Taking into consideration the fact that low melting-point metal particles act as a defect during deformation of a base material due to their inconsistency with the base metal, expansion in particle size of the low melting-point metal particles reduces ductility as compared with the case where fine particles are dispersed. Therefore, there is a problem in using Cu-Zn alloy scraps containing a large amount of Bi for manufacturing Cu-Zn alloys containing Pb. Because the decrease in ductility can be suppressed if the content of Bi is as small as 0.6% or less, the Cu-Zn alloy scraps having the composition of (A) or (B) can be used as a raw material for Pb-containing brass.

When Sn and either or both Bi and Pb are added to a Cu-Zn (brass-type) copper alloy matrix, Sn forms a Cu-Zn-Sn ternary-alloy phase, and Bi and Pb are present as an independent phase. Therefore, to cause these low melting-point metals to exist as a low melting-point compound in the matrix, hot extrusion is carried out at a temperature (material temperature) of 400°C or more, and preferably 500°C or more.

When performing machining, particularly a high speed cutting work, on the metal material of the present invention in which a copper alloy is used as a metal matrix, the cutting machine is caused to vibrate while rotating the material at a high speed, resulting in poor machining accuracy. Since a hot extrusion product lacks good straightness, the product after hot extrusion is preferably subjected to a cold drawing process to increase straightness, thereby improving the machining accuracy.

Although it is possible to improve cutting waste processability by increasing the hardness of the material in the cold working, which is a final step of the manufacturing process, excessive cold working increases cutting resistance, damages the tools, and reduces roughness of the machined surface. For this reason, the rate of section area reduction in the final cold work immediately before obtaining the finished product is preferably 5-30%, and more preferably 10-20%.

Contamination by Fe as an impurity is unavoidable if scrap metal is used for manufacturing the metal material of the present invention in which a copper alloy is a metal matrix. A large Fe content, however, causes both large and small crystal particles to be present together and destabilizes the mechanical properties. Therefore, the content of Fe is preferably controlled to 0.5% or less.

### EXAMPLES

The present invention is described below by comparing examples of the present invention in which a copper alloy is a metal matrix with comparative examples. The effects of the present invention will be demonstrated based on this comparison. The examples illustrate only one preferred embodiment of the present invention, which should not be construed as limiting the present invention.

### Example 1

Alloys (Alloys No. 1 to No. 10), containing Cu, Zn, Sn, Bi, and Pb as major raw materials, of which the concentrations have been adjusted to provide the compositions shown in Table 1, were melted and cast into billets with a diameter of 294 mm. Next, the bullets were extruded by hot extrusion under the conditions shown in Table 2 to obtain rods with a diameter of 16.4-19.1 mm. After the hot extrusion, the resulting rods obtained from alloys No. 2-4, 7, and 9 were cooled under the conditions shown in Table 2.

In the cooling after hot extrusion, the cooling rate was adjusted as shown in Table 2 by covering the coil pan, which rolls up the hot extrusion material, with a heat insulating material. After cooling, the rods were processed by cold drawing at a cross-section reduction rate of 5-30%, followed by a finishing process for correction to obtain rods with a diameter 16 mm.

The rods obtained from the alloys No. 1, 5-6, and 8 by hot extrusion were processed by cold drawing at a cross-section reduction rate of 10%, treated with heat under the conditions shown in Table 2, processed again by cold drawing at a cross-section reduction rate of 5-30%, and then subjected to a finishing process for correction to obtain rods with a diameter of 16 mm. For heat treatment, the rods were maintained at a prescribed temperature in an electric furnace for a prescribed period of time, followed by cooling.

The rods (test materials) obtained after the finishing process for correction were tested to determine the content (%) of low melting point compounds, the number of particles, cutting work performance, and the amount of Pb elution by a Pb elution test according to the following methods. The measurement and evaluation results are shown in Table 4.

### Content (%) of low melting point compounds:

Specimens were tested by producing EPMA across a section of to determine the percentage of the area of a phase consisting of Bi alone, a phase consisting of Pb alone, and a phase in which Bi and Pb are layered over Sn, and to determine the number of particles of each area by image analysis. The obtained data was converted into volume percentage and the number of particles per unit volume.

### Cutting test:

Cutting work was carried out under the conditions shown in Table 3. Test specimens excellently machined while producing finely cut particles in all conditions were rated as ●, those that produced curled cut scraps in any of the conditions were rated as ○, and those that produced continuous cut scraps in any one of the conditions were rated as ×. Cut products rated either ● or ○ were regarded as acceptable, whereas the products rated as × were rejected.

### Pb elution test:

Ten test specimens, each having a surface area of 3,000 mm², were prepared from the test metal material by cutting, immersed in 1,000 ml of a test solution in a sealed container, and tested according to the method based on the ordinance of the Welfare and Labor Ministry to standardize the test specimens according to the JIS 15A valve contact surface area and internal volume standard. The test specimens measuring 0.01 mg/l or less were accepted (○) and those not measuring 0.01 mg/l or less were rejected (×).

**TABLE 1**

| Alloy No | Composition (mass %) | | | | | |
|---|---|---|---|---|---|---|
| | Cu | Bi | Pb | Sn | Fe | Zn |
| 1 | 59.0 | 1.5 | -- | 0.5 | -- | R |
| 2 | 62.0 | 1.3 | -- | 0.6 | -- | R |
| 3 | 58.5 | 0.3 | -- | 1.3 | -- | R |
| 4 | 61.5 | 0.3 | 0.2 | 0.9 | -- | R |
| 5 | 59.8 | 2.9 | -- | 0.7 | -- | R |
| 6 | 61.8 | 0.7 | 0.3 | 0.4 | -- | R |
| 7 | 61.1 | 1.8 | -- | 1.1 | -- | R |
| 8 | 59.1 | -- | 0.6 | 0.8 | -- | R |
| 9 | 58.9 | 0.8 | 0.2 | 1.2 | -- | R |
| 10 | 60.7 | 2.0 | -- | 1.0 | -- | R |

**TABLE 2**

| Condition No | Extrusion temperature (°C) | Cooling rate after extrusion (°C/sec) | Heat treatment temperature (°C) × time → Cooling |
|---|---|---|---|
| 1 | 490 | -- | 560x60 min→ Air cooling |
| 2 | 530 | 2 | -- |
| 3 | 500 | 1.5 | -- |
| 4 | 570 | 2.5 | -- |
| 5 | 510 | -- | 500×60 min → Air cooling |
| 6 | 540 | -- | 580×15 min→ Water cooling |
| 7 | 600 | 3.3 | -- |
| 8 | 550 | -- | 400×5 min→ Air cooling |
| 9 | 590 | 3 | -- |
| 10 | 480 | 1.2 | -- |

**TABLE 3**

| | |
|---|---|
| Cutting mode | Perimeter cutting |
| Type of tool | TPGN160304 |
| Type of holder | OTGPR2525H3 |
| Name of blade edge | (05 11 6 30 0 0.4) |
| Tool material | K10 |
| Cutting speed | 100mm/min |
| Forwarding amount | 0.05, 0.10, 0.20 mm/rev |
| Cutting amount | 0.5, 1.0, 1.5 mm |
| Lubricant | None |

**TABLE 4**

| Test specimen No | Alloy No | Condition No | Low m.p. compound | | Cutting test | Pb elution test |
|---|---|---|---|---|---|---|
| | | | Content (vol%) | Number of particles/mm³ | | |
| 1 | 1 | 1 | 1.9 | 5.0 × 10⁵ | ● | ○ |
| 2 | 2 | 2 | 1.8 | 4.8 × 10⁵ | ● | ○ |
| 3 | 3 | 3 | 0.35 | 1.1 × 10⁴ | ○ | ○ |
| 4 | 4 | 4 | 0.7 | 2.0 × 10⁴ | ○ | ○ |
| 5 | 5 | 5 | 3.2 | 3.5 × 10⁶ | ● | ○ |
| 6 | 6 | 6 | 1.1 | 2.5 × 10⁵ | ○ | ○ |
| 7 | 7 | 7 | 2.6 | 1.4 × 10⁶ | ● | ○ |
| 8 | 8 | 8 | 1.0 | 6.1 × 10⁴ | ○ | ○ |
| 9 | 9 | 9 | 1.7 | 3.5 × 10⁵ | ● | ○ |
| 10 | 10 | 10 | 2.8 | 5.0 × 10⁶ | ● | ○ |

As can be seen from Table 4, the test materials Nos. 1-10 according to the present invention exhibited excellent machinability regardless of cutting conditions. In addition, all test materials satisfied the regulated standard of 0.01 mg/l or less of Pb elution.

### Comparative Example 1

Alloys (Alloys No. 11 to No. 19), containing Cu, Zn, Sn, Bi, and Pb as major raw materials, of which the concentration was adjusted to provide a composition shown in Table 5, were melted and cast into billets with a diameter of 294 mm. Next, the billets were extruded by hot extrusion under the conditions shown in Table 6 to obtain rods with a diameter of 16.4-19.1 mm. After the hot extrusion, the resulting rods obtained from alloys No. 13-15 and 17 were cooled under the conditions shown in Table 6.

In the cooling after hot extrusion, the cooling rate was adjusted as shown in Table 6 by covering the coil pan, which rolls up the hot extrusion material, with a heat insulating material. After cooling, the rods were processed by cold drawing at a cross-section reduction rate of 5-30%, followed by finishing process for correction to obtain rods with a diameter of 16 mm.

The rods obtained from the alloys No. 11-12, 16, and 18-19 by hot extrusion were processed by cold drawing at a cross-section reduction rate of 10%, treated with heat under the conditions shown in Table 6, processed again by cold drawing at a cross-section reduction rate of 5-30%, and then subjected to finishing process for correction to obtain rods with a diameter of 16 mm. For heat treatment, the rods were maintained at a prescribed temperature in an electric furnace for a prescribed period of time, followed by cooling.

The rods (test materials) obtained after the finishing process for correction were tested to determine of the content (%) of low melting point compounds, the number of particles, cutting work performance, and the amount of Pb elution by a Pb elution test according to the same methods as in Example 1. The measurement and evaluation results are shown in Table 7.

**TABLE 5**

| Alloy No | Composition (mass %) | | | | | |
|---|---|---|---|---|---|---|
| | Cu | Bi | Pb | Sn | Fe | Zn |
| 11 | 60.3 | 0.2 | -- | 0.7 | -- | R |
| 12 | 61.1 | -- | 0.1 | 0.5 | -- | R |
| 13 | 59.5 | 1.4 | 0.7 | 1.2 | -- | R |
| 14 | 60.7 | 7.2 | 0.2 | 3.1 | -- | R |
| 15 | 59.3 | 0.2 | 0.1 | 0.7 | -- | R |
| 16 | 60.7 | 0.7 | 0.8 | 0.4 | -- | R |
| 17 | 58.4 | 1.1 | 0.6 | 0.8 | -- | R |
| 18 | 59.7 | 0.7 | 0.2 | 0.6 | -- | R |
| 19 | 60.4 | 1.6 | 0.03 | 0.7 | -- | R |

**TABLE 6**

| Condition No | Extrusion Temperature (°C) | Cooling rate after extrusion (°C/sec) | Heat treatment temperature (°C) ×time → Cooling |
|---|---|---|---|
| 11 | 620 | -- | 560×10 min→ Air cooling |
| 12 | 570 | -- | 580×60 min→ Water cooling |
| 13 | 610 | 3 | -- |
| 14 | 520 | 1 | -- |
| 15 | 540 | 2.5 | -- |
| 16 | 580 | -- | 590×10 min→ Air cooling |
| 17 | 490 | 15 | -- |
| 18 | 580 | -- | 390×60 min→ Air cooling |
| 19 | 520 | -- | 400×50 min→ Air cooling |

**TABLE 7**

| Test specimen No | Alloy No | Condition No | Low m.p. compound | | Cutting test | Pb elution test |
|---|---|---|---|---|---|---|
| | | | Content (vol%) | Number of particles/mm³ | | |
| 11 | 11 | 11 | 0.34 | 9.2 × 10³ | × | ○ |
| 12 | 12 | 12 | 0.34 | 9.1 × 10³ | × | ○ |
| 13 | 13 | 13 | 2.9 | 2.1 × 10⁶ | ● | × |
| 14 | 14 | 14 | 1.5 | 5.3 × 10⁷ | -- | ○ |
| 15 | 15 | 15 | 0.4 | 9.9 × 10³ | × | ○ |
| 16 | 16 | 16 | 2.1 | 8.9 × 10⁵ | ○ | × |
| 17 | 17 | 17 | 2. 3 | 7.3 × 10³ | × | ○ |
| 18 | 18 | 18 | 1.4 | 9.6 × 10³ | × | ○ |
| 19 | 19 | 19 | 1.9 | 6.9 × 10³ | × | ○ |

As shown in Table 7, test materials No. 11 and No 12 showed a decrease in the number of low melting point alloy particles. These materials did not exhibit sufficient machinability and produced undivided curled cutting scraps depending on the cutting conditions. Test materials No.13 and 16 eluted a large amount of Pb due to the high Pb content. Because test material No. 14 contained a large amount of low melting point alloys, the test specimen broke during drawing and could not be tested for machinability. Test materials No. 15 and No. 17 to No. 19 showed a decrease in the number of low melting point alloy particles and did not exhibit sufficient machinability, producing undivided curled cutting scraps due to a high cooling rate after hot extrusion (Test materials No. 15 and No. 17), a low heat treatment temperature (test material No. 18), and a short heat treatment time (test material 19).

### Example 2

Alloys (Alloys No. 20 to No. 28), containing Cu, Zn, Sn, Bi, and Pb as major raw materials, of which the concentrations were adjusted to provide the compositions shown in Table 8, were melted and cast into billets with a diameter of 294 mm. Next, the resulting billets were extruded by hot extrusion at 600°C to obtain rods with a diameter of 24 mm. The rods were processed by cold drawing at a cross-section reduction rate of 10%, followed by heating at 600°C. Then, after heat treatment, the rods made from the alloys No. 20 to No. 25 were cooled with water and the rods made from the alloys No. 26 to No. 28 were cooled with air. Then, the rods were processed by cold drawing at a cross-section reduction rate of 10%, followed by a finishing process for correction to obtain rods with a diameter of 20 mm. For heat treatment, the rods were heated to a prescribed temperature in an electric furnace, followed by cooling.

The rods (test materials) obtained after the finishing process for correction were tested for determination of the content (%) of low melting point compounds, the number of particles, and cutting performance according to the same methods as in Example 1. Moreover, usability of rods as scrap for manufacturing alloys according to JIS C3000 was evaluated. The results are shown in Table 9.

### Method of evaluating usability as scrap

An alloy in which the component elements were adjusted according to the composition specified in JIS C3604 was melted, cast, and formed into ingots to obtain billets. The billets were extruded by hot extrusion at 650°C to obtain rods with a diameter of 22 mm. The rods were processed by cold drawing at a cross-section reduction rate of 10%, followed by a finishing process for correction to obtain rods with a diameter of 20 mm. Mechanical properties of the resulting rods were compared with those of rods manufactured in the same manner using only the scrap of JIS C3604. The mechanical properties were compared in terms of strength and elongation, both being measured by a tensile test. Rod samples exhibiting equivalent strength and elongation (error: 10% or less) as the rods manufactured from the JIS C3604 scrap were regarded as acceptable (●) and those exhibiting strength and elongation 10% or lower than the rods manufactured from the JIS C3604 scrap were regarded as unacceptable (×). TABLE 8

| Alloy No | Composition (mass %) | | | | | |
|---|---|---|---|---|---|---|
| | Cu | Bi | Pb | Sn | P | Zn |
| 20 | 59.6 | 0.5 | -- | 1.6 | 0.02 | R |
| 21 | 60.2 | 0.5 | 0.1 | 3.2 | 0.03 | R |
| 22 | 61.1 | 0.3 | 0.2 | 3.5 | 0.02 | R |
| 23 | 60.8 | -- | 0.5 | 1.0 | 0.02 | R |
| 24 | 58.9 | 0.2 | 0.2 | 2.7 | 0.04 | R |
| 25 | 59.3 | 0.6 | -- | 3.1 | 0.03 | R |
| 26 | 60.4 | 0.1 | 0.3 | 4.2 | 0.02 | R |
| 27 | 61.5 | 0.3 | 0.2 | 4.5 | 0.04 | R |
| 28 | 59.1 | 0.2 | 0.3 | 2.0 | 0.03 | R |

**TABLE 9**

| Test specimen No | Alloy No | Low m.p. compound | | Cutting test | Evaluation test for usability as scrap |
|---|---|---|---|---|---|
| | | Content (vol□) | Number of particles/mm³ | | |
| 20 | 20 | 1.3 | 6.6 × 10⁶ | ● | ● |
| 21 | 21 | 2.2 | 9.7 × 10⁴ | ○ | ● |
| 22 | 22 | 1.1 | 5.2 × 10⁶ | ● | ● |
| 23 | 23 | 1.2 | 2.7 × 10⁶ | ● | ● |
| 24 | 24 | 0.9 | 8.4 × 10⁵ | ● | ● |
| 25 | 25 | 2.4 | 5.2 × 10⁴ | ○ | ● |
| 26 | 26 | 1.9 | 2.9 × 10⁴ | ○ | ● |
| 27 | 27 | 2.2 | 7.3 × 10⁴ | ○ | ● |
| 28 | 28 | 2.0 | 2.1 × 10⁵ | ○ | ● |

As clear from Table 9, all test materials Nos. 20-28 according to the present invention exhibited excellent machinability regardless of cutting conditions. Scraps of these materials could be used as a raw material for manufacturing JIS C3000 alloys without causing embrittlement.

### Comparative Example 2

Alloys (Alloys No. 29 to No. 36), containing Cu, Zn, Sn, Bi, and Pb as major raw materials, of which the concentrations were adjusted to provide the compositions shown in Table 10, were melted and cast into billets with a diameter of 294 mm. Next, the resulting billets were extruded by hot extrusion at 600°C to obtain rods with a diameter of 24 mm. The rods were processed by cold drawing at a cross-section reduction rate of 10%, followed by heating at 600°C. Then, after heat treatment, the rods made from the alloys No. 29-32, 37 and 38 were cooled with water and the rods made from the alloys No. 33-36 were cooled with air. Then, the rods were processed by cold drawing at a cross-section reduction rate of 10%, followed by a finishing process for correction to obtain rods with a diameter 20 mm. For heat treatment, the rods were heated to a prescribed temperature in an electric furnace, followed by cooling.

The rods (test materials) obtained after the finishing process for correction were tested to determine the content (%) of low melting point compounds, the number of particles, and cutting performance, and evaluated for usability as scrap for manufacturing alloys according to JIS C3000 according to the same methods as in Example 2. The results are shown in Table 11.

**TABLE 10**

| Alloy No | Composition (mass %) | | | | | |
|---|---|---|---|---|---|---|
| | Cu | Bi | Pb | Sn | P | Zn |
| 29 | 59.8 | 0.7 | -- | 3.4 | 0.03 | R |
| 30 | 60.3 | 0.3 | 0.2 | 3.6 | 0.02 | R |
| 31 | 68.8 | 0.1 | 0.4 | 0.9 | 0.02 | R |
| 32 | 62.1 | 0.2 | 0.1 | 2.7 | 0.04 | R |
| 33 | 58.9 | 0.7 | -- | 4.1 | 0.03 | R |
| 34 | 61.2 | -- | 0.3 | 2.2 | 0.04 | R |
| 35 | 60.4 | 0.3 | 0.2 | 4.6 | 0.02 | R |
| 36 | 59.7 | 0.2 | 0.3 | 1.9 | 0.03 | R |
| 37 | 60.1 | 0.6 | -- | 3.4 | 0.01 | R |
| 38 | 58.9 | 0.3 | 0.2 | 1.8 | 0.05 | R |

**TABLE 11**

| Test specimen No | Alloy No | Low m.p. compound | | Cutting test | Evaluation test for usability as scrap |
|---|---|---|---|---|---|
| | | Content (vol□) | Number of particles/mm³ | | |
| 29 | 29 | 1.5 | 2.7 × 10⁴ | Cracked during cutting | × |
| 30 | 30 | 1.1 | 3.2 × 10⁴ | Cracked during cutting | ● |
| 31 | 31 | 0.9 | 7.7 × 10³ | × | ● |
| 32 | 32 | 0.5 | 6.4 × 10³ | × | ● |
| 33 | 33 | 2.2 | 3.6 × 10⁴ | Cracked during cutting | × |
| 34 | 34 | 0.9 | 7.2 × 10³ | × | ● |
| 35 | 35 | 1.4 | 4.5 × 10⁵ | Cracked during cutting | ● |
| 36 | 36 | 1.6 | 7.9 × 10³ | × | ● |
| 37 | 37 | -- | -- | Cracked during casting | ● |
| 38 | 38 | 1.3 | 3.2 × 10⁵ | Cracked during extrusion | ● |

As shown in Table 11, low melting alloys of the test materials No. 29, 30, 33, and 35 are rough and large, and produced cracks according to cutting conditions. In addition, the test materials No. 29 and 33 became brittle when used as scraps for manufacturing alloys according to JIS C3000 due to a large Bi content. The test materials No. 31, 32, 34, and 36 did not exhibit sufficient machinability, producing undivided curled cutting scraps depending on cutting conditions due to a decrease in the number of low melting point alloy particles. The test material No. 37, which contained only a small amount of Pb, could not be machined due to cracks that occurred during casting. The test material No. 38, which contained too large an amount of Pb, could not be tested for machinablity due to cracks that occurred during hot extrusion.

### INDUSTRIAL APPLICABILITY

A metal material exhibiting excellent machinability irrespective of processing conditions, when applied to a metal material for cutting work, particularly to a copper alloy for cutting work, being capable of satisfying the Pb elution control of 0.01 mg/l or less, and being advantageous in terms of production cost and a method for manufacturing the metal material are provided by the present invention. The metal material of the present invention is suitably used for a variety of materials produced by a cutting process such as a wiring accessory, switch, relay, connector, spring for electric equipment, camera component, instrument panel component, clock component, bearing, bush, bolt, nut, washer, spindle, shaft, pivot, sliding spring, valve, metallic ware, fastener, rivet, crochet needle, pin, part of eyeglasses, lighter, and ballpoint pen, bed, curtain rod, shell casing, heat exchanger component, and part of bathroom, toilet, and kitchen.

## Claims

1. A metal material comprising a Cu-Zn alloy in which a low melting point metal phase formed from Sn and Bi is dispersed in the form of particles and in a particle number concentration of 10⁴/mm³ or more.

2. The metal material according to claim 1, wherein the content of Fe in the Cu-Zn alloy is controlled to 0.5% or less.

3. The metal material according to claim 1 or claim 2, wherein the volume percentage of the low melting point metal phase is 0.35-10%.

4. The metal material according to any one of claims 1-3, wherein the Cu-Zn alloy contains 1.0-3.5% of Sn and 0.4-0.6% of Bi.

5. The metal material according to any one of claims 1-3, wherein the Cu-Zn alloy contains 2.0-4.5% of Sn and 0.4-0.6% of Bi.

6. The metal material according to claim 4 or claim 5, wherein the Cu-Zn alloy contains P in an amount of 0.02-0.04%.

7. The metal material according to any one of claims 1-3, wherein the Cu-Zn alloy contains Sn and Bi, with the content of Bi being 0.3-2.9%.

8. The metal material according to any one of claims 1-7, wherein the metal alloy is used for machining and the low melting point metal phase dispersed in the metal matrix is deposited or dispersed in the form of particles adjacent to a hard and brittle alloy phase.

9. The metal material according to claim 8, wherein the volume percentage of the hard and brittle alloy phase adjacent to the low melting point metal phase is 10% or less in the metal matrix.

10. A metal material comprising a Cu-Zn alloy in which a low melting point metal phase formed from Sn and Bi is dispersed in the form of particles and in a particle number concentration of 10⁴/mm³ or more, the metal material comprising 58 to 62% Cu and optionally up to 0,5% Fe, 1,0 to 4,5% Sn, 0,3 to 0,6% Bi, 0,02 to 0,04% P and Zn as remainder.
